# EUROPEAN PATENT APPLICATION

(11) **EP 4 586 252 A1**
(43) Date of publication of application: **16.07.2025**
(21) Application number: 24217325.0
(22) Date of filing: 04.12.2024
(51) Int. Cl.: G11C 7/10

(54) **SEMICONDUCTOR CHIP, SEMICONDUCTOR DEVICE AND DATA STORAGE SYSTEM**

(30) Priority: 09.01.2024 KR 20240003353
(71) Applicant: SK hynix Inc., Bubal-eub Icheon-si Gyeonggi-do 17336 (KR)
(72) Inventor: LIM, Tae Ho, 17336 Icheon-si, Gyeonggi-do (KR); PARK, Ie Ryung, 17336 Icheon-si, Gyeonggi-do (KR)
(74) Representative: Isarpatent

(57) **Abstract**

A semiconductor die that operates using a first clock signal and a semiconductor die that operates using a second clock signal control transmission of data during operation periods using a mask circuit included in each semiconductor die to prevent or reduce the occurrence of data transmission and reception failure due to a difference in the clock signals between the semiconductor dies. Communication performance between the semiconductor dies is improved.

## Description

### CROSS-REFERENCE TO RELATED APPLICATION

The present application claims priority under 35 U.S.C. §119(a) to Korean Patent Application No. 10-2024-0003353 filed in the Korean Intellectual Property Office on January 9, 2024, which is incorporated herein by reference in its entirety.

### BACKGROUND

### 1. Technical Field

Various embodiments of the disclosed technology generally relate to a semiconductor chip, a semiconductor device and a data storage system.

### 2. Related Art

For example, a semiconductor device may be configured with a single semiconductor chip or may be configured with a plurality of semiconductor chips.

When a semiconductor device is configured with a single semiconductor chip, the single semiconductor chip may perform communication with another semiconductor chip which is located outside of the semiconductor device. When a semiconductor device is configured with a plurality of semiconductor chips, the plurality of semiconductor chips may perform communication with another semiconductor chip which is located outside of the semiconductor device, or may perform communication between the plurality of semiconductor chips within the semiconductor device.

Consequently, when performing communication between semiconductor chips with different characteristics, errors may occur during communication between semiconductor chips due to a difference in characteristics among the semiconductor chips.

### SUMMARY

Various embodiments of the disclosed technology are directed to providing measures capable of preventing or reducing occurrence of an error due to a difference in characteristics of semiconductor chips when transmitting and receiving data between the semiconductor chips.

In an embodiment, a semiconductor device may include: a first semiconductor die including a first transmission circuit, a first reception circuit and a first mask circuit, the first mask circuit configured to receive a first data, which is output by the first transmission circuit in accordance with a first clock signal, to output the first data to an outside during a first operation period, and to stop the output of the first data during a second operation period; and a second semiconductor die including a second transmission circuit and a second reception circuit, the second reception circuit being configured to read the first data, which is transmitted from the first semiconductor die and buffered, in accordance with a second clock signal that is different from the first clock signal.

In an embodiment, a semiconductor chip may include: a transmission circuit configured to output data in accordance with a clock signal; and a mask circuit configured to receive the clock signal and the data output from the transmission circuit, wherein the mask circuit bypasses and outputs the data during a first operation period and a second operation period, or bypasses and outputs the data during one of the first operation period and the second operation period, and stops outputting the data during the other period.

In an embodiment, a data storage system may include: at least one memory device; and a controller configured to control an operation of the at least one memory device, the controller including a first chiplet including a mask circuit that receives data in accordance with a first clock signal, outputs the data to an outside during a first operation period and stops output of the data during a second operation period; and a second chiplet including a buffer memory that receives and stores the data, and a reception circuit that reads the data stored in the buffer memory, in accordance with a second clock signal that is different from the first clock signal.

According to embodiments of the disclosed technology, by preventing or reducing occurrence of an error when transmitting and receiving data between semiconductor chips with different characteristics, it is possible to improve communication performance between the semiconductor chips.

### BRIEF DESCRIPTION OF THE DRAWINGS

FIG. 1 is a diagram illustrating a schematic configuration of a data storage system according to an embodiment of the disclosure.
FIG. 2 is a diagram illustrating a schematic configuration of a semiconductor device according to an embodiment of the disclosure.
FIG. 3 is a diagram illustrating a method in which dies included in a semiconductor device transmit and receive data according to an embodiment of the disclosure.
FIG. 4 is a diagram illustrating a method of operating a mask circuit in a semiconductor die according to an embodiment of the disclosure.
FIG. 5 is a diagram illustrating the structure of a mask circuit included in a semiconductor die according to an embodiment of the disclosure.
FIG. 6 is a diagram illustrating a method in which dies included in a semiconductor device transmit and receive data according to an embodiment of the disclosure.
FIG. 7 is a diagram illustrating a schematic configuration of a semiconductor device according to an embodiment of the disclosure.
FIG. 8 is a diagram illustrating a method of operating mask circuits included in semiconductor dies illustrated in FIG. 7.

### DETAILED DESCRIPTION

In the following description of examples or embodiments of the present disclosure, reference will be made to the accompanying drawings in which it is shown by way of illustration specific examples or embodiments that can be implemented, and in which the same reference numerals and signs can be used to designate the same or like components even when they are shown in different accompanying drawings. Further, in the following description of examples or embodiments of the present disclosure, detailed descriptions of well-known functions and components incorporated herein will be omitted when it is determined that the description may make the subject matter in some embodiments of the present disclosure more unclear. The terms such as "including", "having", "containing", "constituting" "made up of', and "formed of' used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the present disclosure. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

When time relative terms, such as "after," "subsequent to," "next," "before," and the like, are used to describe processes or operations of elements or configurations, or flows or steps in operating, processing, or manufacturing methods, these terms may be used to describe non-consecutive or non-sequential processes or operations unless the term "directly" or "immediately" is used together.

In addition, when any dimensions, relative sizes etc. are mentioned, it should be considered that numerical values for elements or features, or corresponding information (e.g., level, range, etc.) include a tolerance or error margin that may be caused by various factors (e.g., process factors, internal or external impact, noise, etc.) even when a relevant description is not specified. Further, the term "may" fully encompasses all the meanings of the term "can".

Hereinafter, various embodiments of the present disclosure will be described in detail with reference to accompanying drawings.

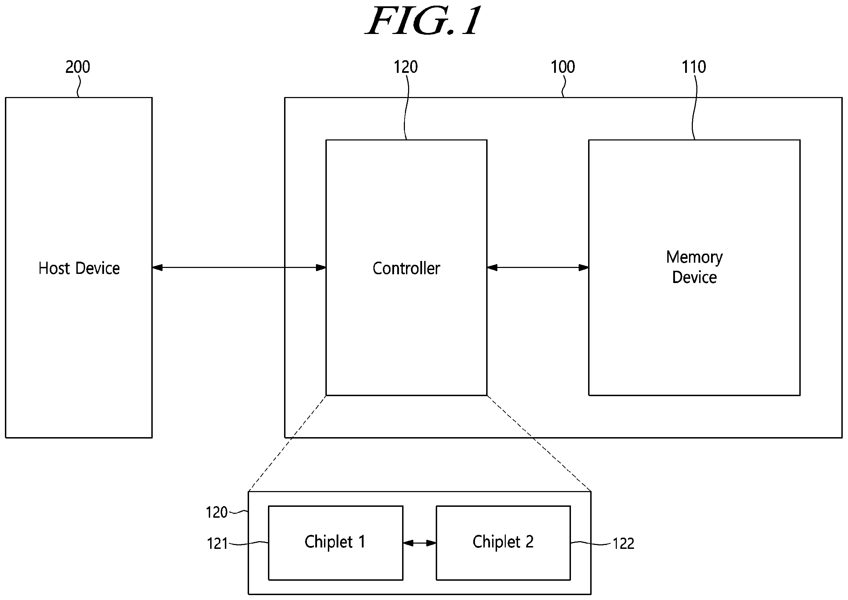

FIG. 1 is a diagram illustrating a schematic configuration of a data storage system according to an embodiment of the disclosure.

Referring to FIG. 1, a data storage system 100 may include at least one memory device 110. The data storage system 100 may include a controller 120, which controls the operation of the memory device 110.

The memory device 110 may be, for example, a volatile memory such as a DRAM, an SDRAM, a DDR SDRAM and an LPDDR SDRAM, but embodiments of the disclosed technology are not limited thereto.

The memory device 110 may be a nonvolatile memory. For example, the memory device 110 may be implemented into various types such as a NAND flash memory, a 3D NAND flash memory, a NOR flash memory, a resistive random access memory, a phase-change random access memory, a magnetoresistive random access memory, a ferroelectric random access memory and a spin transfer torque random access memory. The memory device 110 may be implemented into a three-dimensional array structure. Embodiment disclosed herein may be used in a flash memory in which a charge storage layer is configured with a floating gate as well as in a charge trap flash memory in which a charge storage layer is configured with an insulating layer.

The data storage system 100 may include a plurality of memory devices 110, and some of the plurality of memory devices 110 may be volatile memories and the others may be nonvolatile memories.

The controller 120 may control the operation of the memory device 110. For example, the controller 120 may control an operation of writing data to the memory device 110 or reading or erasing data written to the memory device 110, according to a command inputted from the outside. The controller 120 may control the operation of the memory device 110 regardless or in the absence of an external request.

For example, the controller 120 may control the operation of the memory device 110 according to a request from a host device 200.

For example, the host device 200 may be a computer, an ultra mobile PC (UMPC), a workstation, a personal digital assistant (PDA), a tablet, a mobile phone, a smartphone, an e-book, a portable multimedia player (PMP), a portable game player, a navigation device, a black box, a digital camera, a digital multimedia broadcasting (DMB) player, a smart television, a digital audio recorder, a digital audio player, a digital picture recorder, a digital picture player, a digital video recorder, a digital video player, a storage configuring a data center, one of various electronic devices configuring a home network, one of various electronic devices configuring a telematics network, an RFID (radio frequency identification) device, a mobility device (e.g., a vehicle, a robot or a drone) capable of driving under human control or autonomous driving, or the like. Alternatively, the host device 200 may be a virtual/augmented reality device that provides a 2D or 3D virtual reality image or augmented reality image. In addition, the host device 200 may be any one of various electronic devices, each of which requires a data storage system 100 capable of storing data.

The host device 200 may include at least one operating system. The operating system may manage and control overall functions and operations of the host device 200. The operating system may control the interoperation between the host device 200 and the data storage system 100. The operating system may be classified into a general operating system and a mobile operating system depending on the mobility of the host device 200.

The host device 200 may perform data processing using a memory included in the host device 200. The host device 200 may also perform data processing using the data storage system 100, which is located outside the host device 200.

The host device 200 may perform communication with the data storage system 100 through a preset interface.

For example, the host device 200 may communicate with the data storage system 100 through a Compute Express Link (CXL) interface. The host device 200 may be set as a CXL root port, and the data storage system 100 may be set as a CXL end point. Since the host device 200 communicates with the data storage system 100 through the CXL interface, a low-latency high-bandwidth access environment may be implemented in a high capacity structure that communicates with the data storage system 100.

In other embodiments, the host device 200 may communicate with the data storage system 100 through an interface other than a CXL interface.

The host device 200 and the data storage system 100 may communicate through at least one from among various interface protocols such as a USB (universal serial bus) protocol, an MMC (multimedia card) protocol, a PCI (peripheral component interconnection) protocol, a PCI-E (PCI-express) protocol, an ATA (advanced technology attachment) protocol, a serial-ATA protocol, a parallel-ATA protocol, an SCSI (small computer system interface) protocol, an ESDI (enhanced small disk interface) protocol and an IDE (integrated drive electronics) protocol, as non-limiting examples.

As such, the type and number of host devices 200 that perform communication with the data storage system 100, and the communication interface between the data storage system 100 and the host device 200, may vary.

The controller 120 included in the data storage system 100 that performs communication with the host device 200 may perform communication with the memory device 110 through a bus.

Each of the controller 120 and the memory device 110 may be configured with a single chip, or may be configured with a plurality of chiplets. For example, the controller 120 may include a first chiplet 121 and a second chiplet 122. The first chiplet 121 and the second chiplet 122 may perform separate functions. For example, the first chiplet 121 may provide an interface function with the host device 200 and the second chiplet 122 may provide an interface function with the memory device 110, but embodiments of the disclosure are not limited thereto. For example, the controller 120 may be configured with at least three chiplets.

As such, when the controller 120 included in the data storage system 100 is configured with a plurality of chiplets, data transmission and reception may be performed among multiple chiplets.

Disclosed embodiments may provide measures capable of improving communication performance during data transmission and reception between chiplets. Embodiments of the disclosed technology may be used in controller 120 as an example as well as in examples in which communication is performed between chiplets, or between chips in a semiconductor device that includes a plurality of chiplets or a plurality of semiconductor chips.

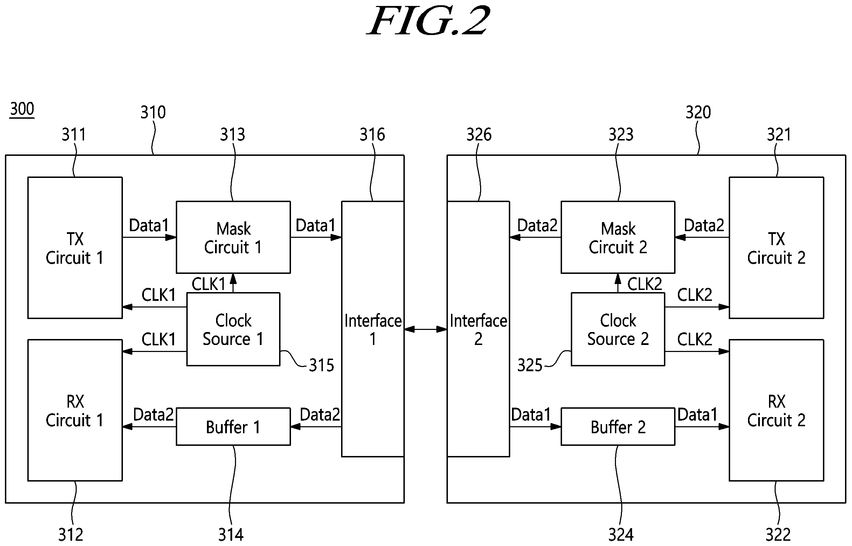

FIG. 2 is a diagram illustrating a schematic configuration of a semiconductor device according to an embodiment of the disclosure.

Referring to FIG. 2, a semiconductor device 300 may include a first semiconductor die 310 and a second semiconductor die 320. Each of the first semiconductor die 310 and the second semiconductor die 320 may be a semiconductor chip. Alternatively, each of the first semiconductor die 310 and the second semiconductor die 320 may be a chiplet. In chiplet form, the first semiconductor die 310 and the second semiconductor die 320 each may be packaged to configure a semiconductor device 300.

The first semiconductor die 310 may include a first transmission circuit 311 and a first reception circuit 312. The first transmission circuit 311 may output data to be transmitted to the outside. The first reception circuit 312 may read data received from the outside.

The first semiconductor die 310 may include a first mask circuit 313. The first mask circuit 313 may receive the data output from the first transmission circuit 311 and control output of the corresponding data.

The first semiconductor die 310 may include a first buffer memory 314. The first buffer memory 314 may buffer data received from the outside. The first buffer memory 314 may be a volatile memory such as an SRAM, but examples are not limited thereto.

The first semiconductor die 310 may include a first clock source 315. The first clock source 315 may output a first clock signal CLK1 to the first transmission circuit 311, the first reception circuit 312 and the first mask circuit 313. The first transmission circuit 311, the first reception circuit 312 and the first mask circuit 313 may operate on the basis of the first clock signal CLK1.

The first semiconductor die 310 may include a first interface 316. The first interface 316 may mean a physical layer, and may transmit data to the outside of the first semiconductor die 310 or receive data from the outside.

The second semiconductor die 320 may include a second transmission circuit 321, a second reception circuit 322, a second mask circuit 323, a second buffer memory 324, a second clock source 325 and a second interface 326.

At least some of the components included in the second semiconductor die 320 may correspond to components included in the first semiconductor die 310.

The second transmission circuit 321 may output data to be transmitted to the outside, and the second reception circuit 322 may read data received from the outside. The second mask circuit 323 may receive the data output from the second transmission circuit 321 and control output of the corresponding data.

The second buffer memory 324 may buffer data received from the outside.

The second clock source 325 may output a second clock signal CLK2 to the second transmission circuit 321, the second reception circuit 322 and the second mask circuit 323. The second reception circuit 322 and the second mask circuit 323 may operate on the basis of the second clock signal CLK2.

The second interface 326 may transmit data to the outside of the second semiconductor die 320 or receive data from the outside.

Data may be transmitted and received between the first semiconductor die 310 and the second semiconductor die 320 through the first interface 316 and the second interface 326.

When data is transmitted from the first semiconductor die 310 to the second semiconductor die 320, the first semiconductor die 310 may correspond to a transmission die, and the second semiconductor die 320 may correspond to a reception die. When data is transmitted from the second semiconductor die 320 to the first semiconductor die 310, the second semiconductor die 320 may correspond to a transmission die, and the first semiconductor die 310 may correspond to a reception die.

The first clock signal CLK1 that is output from the first clock source 315 may be different from the second clock signal CLK2 output from the second clock source 325. For example, the frequency of the first clock signal CLK1 may be greater than the frequency of the second clock signal CLK2. Alternatively, the frequency of the first clock signal CLK1 may be lower than the frequency of the second clock signal CLK2.

As a result, an error or a fail may occur when transmitting and receiving data between the first semiconductor die 310 and the second semiconductor die 320 because the frequency of the first clock signal CLK1, which is used in a first transmission circuit 311 that outputs data from the first semiconductor die 310 and the first reception circuit 312 that reads data, is different from the frequency of the second clock signal CLK2, which is used in a second transmission circuit 321 that outputs data from the second semiconductor die 320 and the second reception circuit 322 that reads data.

The first mask circuit 313 and the first buffer memory 314 included in the first semiconductor die 310 and the second mask circuit 323 and the second buffer memory 324 included in the second semiconductor die 320 may prevent or reduce an error or a fail that may occur when transmitting and receiving data between the first semiconductor die 310 and the second semiconductor die 320.

The first mask circuit 313 and the second mask circuit 323 may control output of data received from the first transmission circuit 311 and the second transmission circuit 321, respectively. The first mask circuit 313 and the second mask circuit 323 may adjust timing for the output of data from the first transmission circuit 311 and the second transmission circuit 321 to the outside. These capabilities prevent a fail such as an overflow from occurring in a buffer memory due to the difference between data transmission timing and data read timing.

Each of the first buffer memory 314 and the second buffer memory 324 may buffer data received from the outside, thereby preventing or reducing a fail due to the difference between a data reception timing and a read timing of each of the first reception circuit 312 and the second reception circuit 322.

For example, the first transmission circuit 311 may output first data Datal in accordance with the first clock signal CLK1. The first mask circuit 313 may receive the first data Datal. The first mask circuit 313 may control whether to output the first data Datal, while operating in accordance with the first clock signal CLK1.

The first mask circuit 313 may output the first data Datal to the outside during a first operation period. The first mask circuit 313 may stop outputting the first data Datal to the outside during a second operation period. Stopping the first mask circuit 313 from outputting the first data Datal may be referred to as a masking or gating operation.

The first data Datal outputted from the first mask circuit 313 through the first interface 316 and the second interface 326 may be stored in the second buffer memory 324 included in the second semiconductor die 320.

The second reception circuit 322 included in the second semiconductor die 320 may read the first data Datal stored in the second buffer memory 324, in accordance with the second clock signal CLK2.

Since the first mask circuit 313 outputs the first data Datal during the first operation period and stops outputting the first data Datal during the second operation period, the frequency at which data is transmitted from the first semiconductor die 310 to the second semiconductor die 320 may be adjusted to be different from the frequency of the first clock signal CLK1. Even when the frequency of the first clock signal CLK1 and the frequency of the second clock signal CLK2 are different, the frequency at which data is transmitted from the first semiconductor die 310 to the second semiconductor die 320 can be adjusted to be different from the frequency of the first clock signal CLK1. As a result, it is possible to prevent or reduce occurrences of a fail during transmission and reception of data due to the difference between the frequency of the first clock signal CLK1 and the frequency of the second clock signal CLK2.

Similarly, the second transmission circuit 321 may output second data Data2 in accordance with the second clock signal CLK2. The second mask circuit 323 may receive the second data Data2, and may control whether to output the second data Data2, while operating in accordance with the second clock signal CLK2.

For example, the second mask circuit 323 may output the second data Data2 to the outside during a third operation period. The second mask circuit 323 may stop outputting the second data Data2 to the outside during a fourth operation period.

The second data Data2 outputted from the second mask circuit 323 and transmitted to the first semiconductor die 310 may be stored in the first buffer memory 314.

The first reception circuit 312 may read the second data Data2 stored in the first buffer memory 314, in accordance with the first clock signal CLK1.

The frequency at which the second data Data2, which is output from the second transmission circuit 321, is transmitted by the second mask circuit 323 to the first semiconductor die 310 may be adjusted to be different from the frequency of the second clock signal CLK2. Accordingly, it is possible to prevent or reduce a fail likely to occur due to the difference between the frequency of the first clock signal CLK1 and the frequency of the second clock signal CLK2 in an operation of reading the second data Data2 by the first reception circuit 312.

One of the first mask circuit 313 and the second mask circuit 323 may perform a masking or gating operation, and the other may not perform a masking or gating operation.

The operation methods of the first mask circuit 313 and the second mask circuit 323 may be determined in consideration of the difference between the first clock signal CLK1 and the second clock signal CLK2, the sizes of the first buffer memory 314 and the second buffer memory 324, and other similar factors.

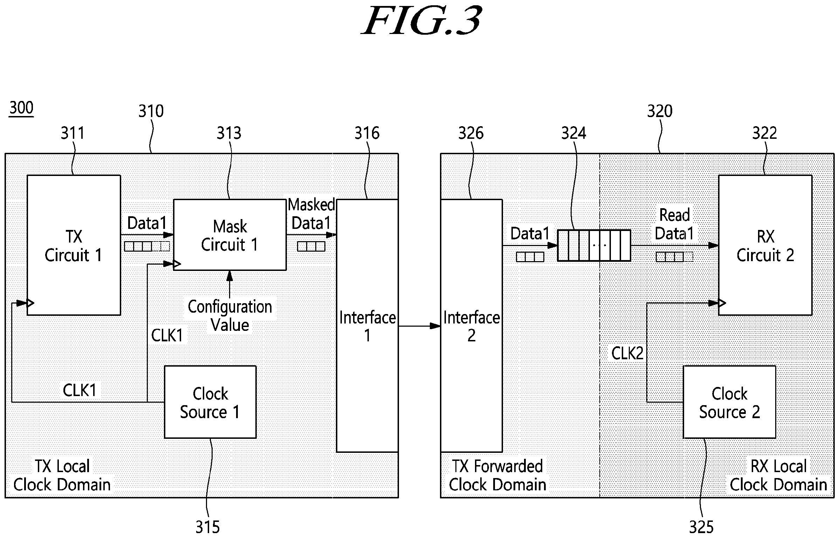

FIG. 3 is a diagram illustrating a method in which dies included in a semiconductor device transmit and receive data according to an embodiment of the disclosure.

In FIG. 3, a first semiconductor die 310 transmits data to a second semiconductor die 320. FIG. 3 mainly illustrates a configuration for transmission of data among components included in the first semiconductor die 310 and a configuration for reception of data among components included in the second semiconductor die 320.

A first transmission circuit 311 included in the first semiconductor die 310 may output first data Datal in accordance with first clock signal CLK1. The first data Datal may be transmitted to a first mask circuit 313.

The first mask circuit 313 may control the output of the first data Datal.

For example, the first mask circuit 313 may operate on the basis of a configuration value. Using the configuration value, the first mask circuit 313 may output the first data Datal to the outside during a first operation period and may not output the first data Datal to the outside during a second operation period. The first mask circuit 313 may stop the output of the first data Datal during the second operation period.

The first operation period and the second operation period of the first mask circuit 313 may be set on the basis of the configuration value.

For example, the configuration value may be a value that is set on the basis of the difference between the frequency of the first clock signal CLK1, which is output from a first clock source 315 of the first semiconductor die 310, and the frequency of second clock signal CLK2, which is output from a second clock source 325 of the second semiconductor die 320.

Alternatively, the configuration value may be a value that is derived in the process of training the data transmission and reception operations of the first semiconductor die 310 and the second semiconductor die 320. The configuration value may be a value that is derived through a training process that reflects at least one of the differences between the frequency of the first clock signal CLK1 and the frequency of a second clock signal CLK2, and the difference between the characteristics of the first semiconductor die 310 and the characteristics of the second semiconductor die 320.

Alternatively, the configuration value may be a value that is set on the basis of the size of a second buffer memory 324 included in the second semiconductor die 320, which corresponds to a reception die. When the size of the first buffer memory 314 included in the first semiconductor die 310 and the size of the second buffer memory 324 included in the second semiconductor die 320 are the same, the configuration value that is input to the first mask circuit 313 may be regarded as a value that is set on the basis of the size of the first buffer memory 314.

Operation of the first mask circuit 313 is divided into a first operation period and a second operation period by the configuration value. Dividing the operation into two operation periods controls whether first data Datal is output by the first transmission circuit 311.

For example, the first transmission circuit 311 may output five first data Datal during a predetermined period in accordance with the first clock signal CLK1. The first mask circuit 313 may receive the first data Datal outputted from the first transmission circuit 311 and control whether to output the first data Datal. The first mask circuit 313 may output only three first data Datal during the predetermined period in which the five first data Datal may be outputted in accordance with the first clock signal CLK1 by the first transmission circuit 311. In a period that the five first data Datal are capable of being outputted in accordance with the first clock signal CLK1, only three first data Datal may be outputted from the first mask circuit 313.

For example, the first mask circuit 313 may output the first data Datal to the outside during the same period of time in which the first transmission circuit 311 may output three first data Datal. Then, the first mask circuit 313 may stop outputting the first data Datal, but the first transmission circuit 311 continues to output two first data Datal. Since the first mask circuit 313 controls whether to output the first data Datal and in this example only outputs three first data Datal when the first transmission circuit 311 outputs five first data Datal, the transmission frequency of the first data Datal transmitted to the outside from the first semiconductor die 310 may be controlled to be different from the frequency of the first clock signal CLK1.

The first data Datal outputted by the first mask circuit 313 may be stored in the second buffer memory 324 included in the second semiconductor die 320 through a first interface 316 and a second interface 326.

A second reception circuit 322 may receive the second clock signal CLK2 from a second clock source 325. The second reception circuit 322 may read the first data Datal stored in the second buffer memory 324 in accordance with the second clock signal CLK2.

During a period in which the first transmission circuit 311 may transmit five first data Datal in accordance with a first clock signal CLK1, three first data Datal may be transmitted to the second semiconductor die 320 by the first mask circuit 313 to be stored in the second buffer memory 324. During a corresponding period, the second reception circuit 322 may read the three first data Datal from the second buffer memory 324.

A fail may occur in a situation in which the second reception circuit 322 reads at least four first data Datal based on the frequency of either the second clock signal CLK2 or the size of the second buffer memory 324, since first data Datal to be transmitted to the second semiconductor die 320 is adjusted by the first mask circuit 313, an operation of reading the first data Datal may be performed without a fail such as an overflow of the second buffer memory 324 or a fail in the read operation of the second reception circuit 322.

As described in the above example, the configuration value inputted to the first mask circuit 313 may be a value that is set in advance depending on the difference between the frequencies of clock signals, the difference between the characteristics of semiconductor dies, the size of a buffer memory, or the like, or may be a value that is variably set according to the operation of the semiconductor device 300.

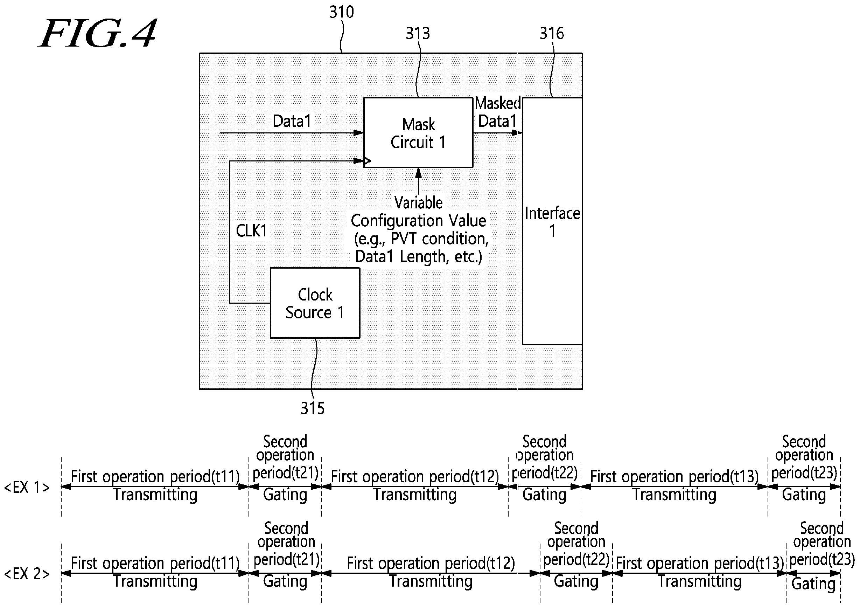

FIG. 4 is a diagram illustrating a method of operating a mask circuit in a semiconductor die according to an embodiment of the disclosure.

Referring to FIG. 4, a first mask circuit 313, a first clock source 315 and a first interface 316 included in a first semiconductor die 310 are illustrated.

The first mask circuit 313 may receive a first clock signal CLK1 and a first data Datal.

The first mask circuit 313 may output the first data Datal to the outside through the first interface 316 during a first operation period. The first mask circuit 313 may stop outputting the first data Datal during a second operation period.

The first operation period and the second operation period may be set in advance on the basis of the characteristics of semiconductor dies or through a training on the semiconductor dies.

For example, the length of the first operation period and the length of the second operation period may be set on the basis of the difference between the frequency of the first clock signal CLK1 used in the first semiconductor die 310 and the frequency of the second clock signal CLK2 used in the second semiconductor die 320, which communicates with the first semiconductor die 310.

In another example, the length of the first operation period and the length of the second operation period may be set on the basis of the sizes of buffer memories included in the first semiconductor die 310 and the second semiconductor die 320.

The length of the first operation period and the length of the second operation period may be set so that a transmission or read fail does not occur in data transmitted from the first semiconductor die 310 to the second semiconductor die 320 due to the difference between the frequencies of clock signals or limitations in the sizes of buffer memories.

The length of the first operation period and the length of the second operation period may be set on the basis of a configuration value, which may be a fixed value, that is input to the first mask circuit 313.

For example, as illustrated in <EX 1>, lengths t11, t12 and t13 of the first operation period may be constant. Lengths t21, t22 and t23 of the second operation period may be constant. The first operation period and the second operation period may be continuous periods. The first operation period and the second operation period may alternate.

The length of the first operation period may be greater than the length of the second operation period. The frequency at which the first data Datal is transmitted by the first mask circuit 313 may be adjusted, and by setting the length of the first operation period to be greater than the length of the second operation period, it is possible to prevent or reduce degradation in transmission performance. Alternatively, depending on the characteristics or operating condition of a semiconductor die, the length of the second operation period may be greater than the length of the first operation period.

In another example, the length of the first operation period and the length of the second operation period may be varied. As in an example illustrated in <EX 2>, lengths t11, t12 and t13 of the first operation period may not be the same. Lengths t21, t22 and t23 of the second operation period may not be the same.

The length of the first operation period and the length of the second operation period may be varied by adjusting the configuration value inputted to the first mask circuit 313.

For example, the configuration value may be set on the basis of condition information including at least one of the process, voltage and temperature of the first semiconductor die 310. The configuration value may be set on the basis of condition information including at least one of the process, voltage and temperature of the second semiconductor die 320.

When a condition change that may affect the data transmission/reception and read performance of the first semiconductor die 310 or the second semiconductor die 320 occurs, by inputting a changed configuration value to the first mask circuit 313, the length of the first operation period and the length of the second operation period may be adjusted. The transmission frequency of the first data Datal outputted to the outside through the first mask circuit 313 may be varied.

Alternatively, the configuration value may be set on the basis of the length of the first data Datal transmitted from the first semiconductor die 310. When the length of the first data Datal is greater than a predetermined value, the configuration value may be adjusted in consideration of the length of the first data Datal so that the length of the first operation period and the length of the second operation period may be varied. For example, the configuration value may be adjusted so that the length of the second operation period is increased before the first data Datal is transmitted, to allow the second buffer memory 324 to be emptied, and the length of the first operation period is increased or adjusted in accordance with a period in which the first data Datal is transmitted, to allow the first data Datal to be transmitted without a fail.

By variably controlling the configuration value that sets the length of the first operation period, in which the first mask circuit 313 outputs the first data Datal, and the length of the second operation period, in which the first mask circuit 313 stops outputting the first data Datal, data transmission and reception may be performed according to a condition change that occurs during the operations of the first semiconductor die 310 and the second semiconductor die 320.

The configuration value may be input to at least a part of the components included in the first mask circuit 313. The structure of the first mask circuit 313 may be implemented in various ways. For example, the first mask circuit 313 may be implemented as a structure including a plurality of counters.

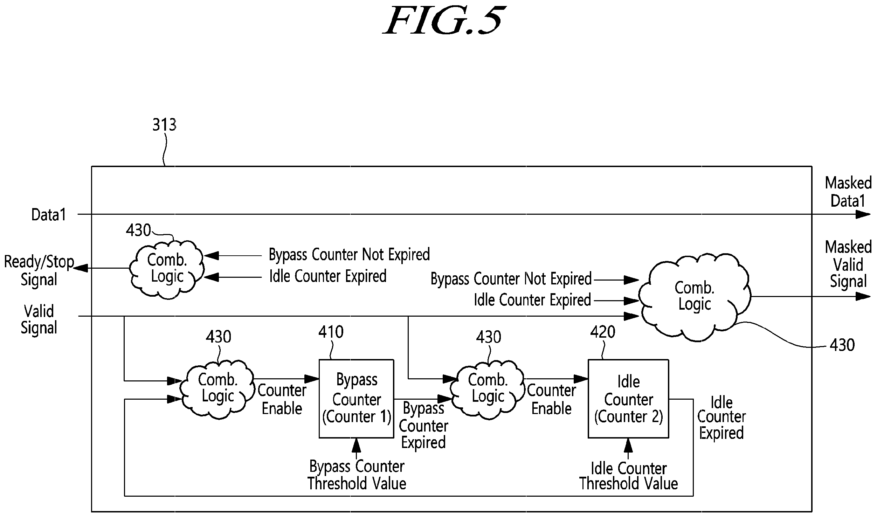

FIG. 5 is a diagram illustrating the structure of a mask circuit included in a semiconductor die according to an embodiment of the disclosure.

Referring to FIG. 5, the structure of a first mask circuit 313 is illustrated as an example. The first mask circuit 313 may include a first counter 410 and a second counter 420.

The first mask circuit 313 may include at least one combinational logic circuit 430 for controlling the operations of the first counter 410 and the second counter 420 or for outputting a signal which controls whether to output the first data Datal. The combinational logic circuit 430, as a circuit that outputs an output signal based on an input signal, may be implemented in various ways.

The first counter 410 may be a counter that controls a first operation period. The second counter 420 may be a counter that controls a second operation period. The first mask circuit 313 may output the first data Datal during a period in which the first counter 410 operates, and may not output the first data Datal during a period in which the second counter 420 operates.

The first counter 410 and the second counter 420 may operate on the basis of a counter threshold value. The counter threshold value may be a value that is set on the basis of the length of the first operation period and the length of the second operation period. The counter threshold value may be the above-described configuration value that is input to the first mask circuit 313, or may be a value that is derived on the basis of the configuration value.

The first counter 410 may operate on the basis of a bypass counter threshold value. The second counter 420 may operate on the basis of an idle counter threshold value.

The first counter 410 and the second counter 420 may operate on the basis of a valid signal that is input together with the first data Datal. The first counter 410 and the second counter 420 may operate alternately.

For example, the first counter 410 may perform a counting operation according to a valid signal that is input to the first mask circuit 313 together with the first data Datal.

A period in which a counting operation by the first counter 410 is performed may correspond to a first operation period. The first counter 410 may end counting on the basis of a bypass counter threshold value. The bypass counter threshold value may be a value that is set on the basis of the first operation period, or may be a value that is set in proportion to the first operation period.

During the period in which the counting operation by the first counter 410 is performed, the first mask circuit 313 may bypass and output the first data Datal to the outside.

When a counting value by the first counter 410 reaches the bypass counter threshold value, the counting operation of the first counter 410 may be ended. When the counting operation by the first counter 410 is ended, a counter enable signal may be input to the second counter 420. A counting operation by the second counter 420 may be started.

The second counter 420 may perform a counting operation on the basis of a valid signal that is input to the first mask circuit 313. Alternatively, the second counter 420 may perform a counting operation on the basis of a first clock signal CLK1, which is input to the first mask circuit 313. In other examples, the second counter 420 may perform a counting operation without a valid signal.

A period in which a counting operation by the second counter 420 is performed may correspond to a second operation period. The second counter 420 may end counting on the basis of an idle counter threshold value. The second counter 420 may perform the counting operation on the basis of a valid signal or a first clock signal CLK1 until a counting value reaches the idle counter threshold value. Alternatively, the second counter 420 may perform the counting operation without receiving a valid signal during at least a partial period of the second operation period. During the second operation period in which masking or gating of data is required, the second counter 420 may operate both when there is data to be transmitted and when there is no data to be transmitted. The idle counter threshold value may be a value that is set on the basis of the second operation period, or may be a value that is set in proportion to the second operation period.

During the period in which a counting operation by the second counter 420 is performed, the first mask circuit 313 may stop outputting the first data Datal. When the counting operation of the first counter 410 is ended and the counting operation of the second counter 420 is started, the first mask circuit 313 may output a transmission stop signal to the first transmission circuit 311. The first mask circuit 313 may not receive the first data Datal from the first transmission circuit 311 during the second operation period.

When a counting value by the second counter 420 reaches the idle counter threshold value, the counting operation of the second counter 420 may be ended. When the counting operation by the second counter 420 is ended, a counter enable signal may be input to the first counter 410. A counting operation by the first counter 410 may be started.

When the counting operation by the second counter 420 is ended, the first mask circuit 313 may output a transmission ready signal to the first transmission circuit 311. The first mask circuit 313 may receive the first data Datal from the first transmission circuit 311, and may bypass and output the received first data Datal to the outside.

The length of the first operation period and the length of the second operation period may be adjusted according to the bypass counter threshold value inputted to the first counter 410 and the idle counter threshold value inputted to the second counter 420, and output of the first data Datal by the first mask circuit 313 may be controlled.

The output of the first data Datal may be controlled by the first mask circuit 313, and the transmission frequency of the first data Datal output to the outside through the first mask circuit 313 may be adjusted to be different from the frequency of the first clock signal CLK1.

During an operation period, a mask circuit may not stop output of data to the outside, but instead may bypass and output the data.

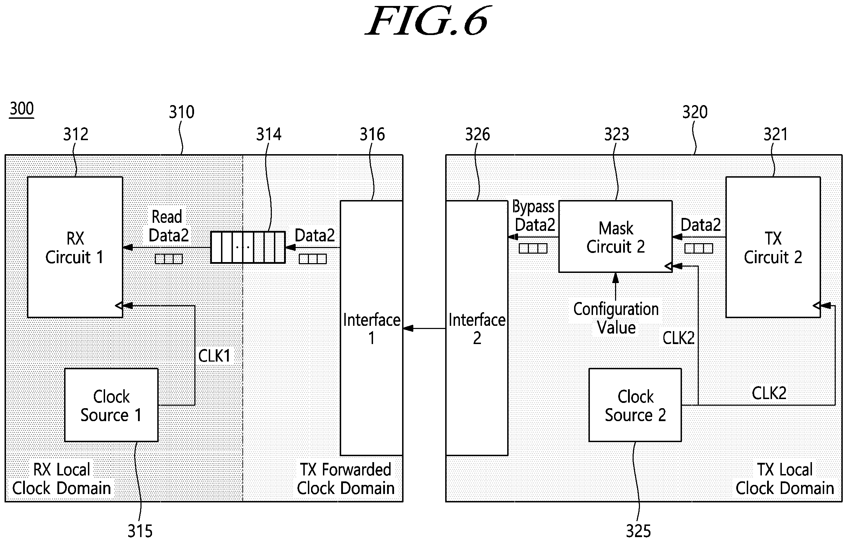

FIG. 6 is a diagram illustrating a method in which dies included in a semiconductor device transmit and receive data according to an embodiment of the disclosure.

In FIG. 6, second data Data2 is transmitted from a second semiconductor die 320 to a first semiconductor die 310 as an example. The first semiconductor die 310 may operate on the basis of a first clock signal CLK1, which is output from a first clock source 315. The second semiconductor die 320 may operate on the basis of a second clock signal CLK2, which is output from a second clock source 325.

The frequency of the first clock signal CLK1 and the frequency of the second clock signal CLK2 may be different. For example, the frequency of the first clock signal CLK1 may be greater than the frequency of the second clock signal CLK2.

When transmitting the first data Datal from the first semiconductor die 310 to the second semiconductor die 320, a masking or gating operation by a first mask circuit 313 may be required.

On the other hand, when transmitting second data Data2 from the second semiconductor die 320 to the first semiconductor die 310, a masking or gating operation by a second mask circuit 323 may not be required.

For example, the second transmission circuit 321 may output second data Data2 in accordance with the second clock signal CLK2. The second mask circuit 323 may receive the second data Data2.

The second mask circuit 323 may have a structure similar to that of the first mask circuit 313 illustrated in FIG. 5. The counter threshold value of a counter included in the second mask circuit 323 may be different from the counter threshold value of a counter included in the first mask circuit 313.

During an operation period, the second mask circuit 323 may bypass and output to the outside the second data Data2, which was input to the second mask circuit 323 from the second transmission circuit 321. Among counters included in the second mask circuit 323, a counter that operates during a bypass period may operate continuously.

The second data Data2 outputted from the second mask circuit 323 may be stored in the first buffer memory 314 included in the first semiconductor die 310. The first reception circuit 312 may read the second data Data2 stored in the first buffer memory 314, in accordance with the first clock signal CLK1.

Since the frequency of the first clock signal CLK1 is greater than the frequency of the second clock signal CLK2, the read period of the second data Data2 may be smaller than the transmission period of the second data Data2. Since there is a low possibility that an overflow of the first buffer memory 314 occurs or a read fail by the first reception circuit 312 occurs, the second mask circuit 323 may bypass and output the second data Data2.

The configuration value of the second mask circuit 323 may be varied depending on a change in the condition information of the first semiconductor die 310 and the second semiconductor die 320, the length of the second data Data2, and other similar factors. The second mask circuit 323 may temporarily perform a masking or gating operation. The length and timing of a period in which the masking or gating operation by the second mask circuit 323 is performed may be different from the length and timing of a period in which the masking or gating operation by the first mask circuit 313 is performed.

A transmission circuit and a reception circuit included in a semiconductor die may operate using different clock signals. By implementing a masking or gating operation using a mask circuit, it is possible to prevent or reduce occurrence of a fail when transmitting and receiving data between semiconductor dies.

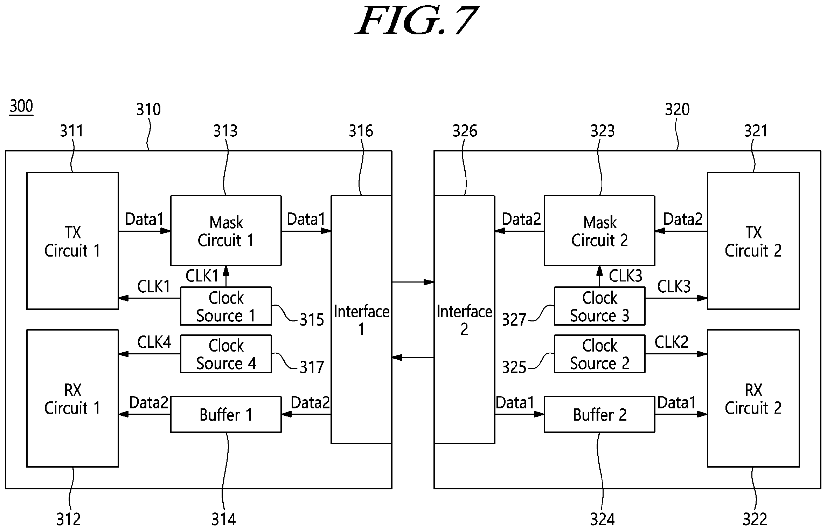

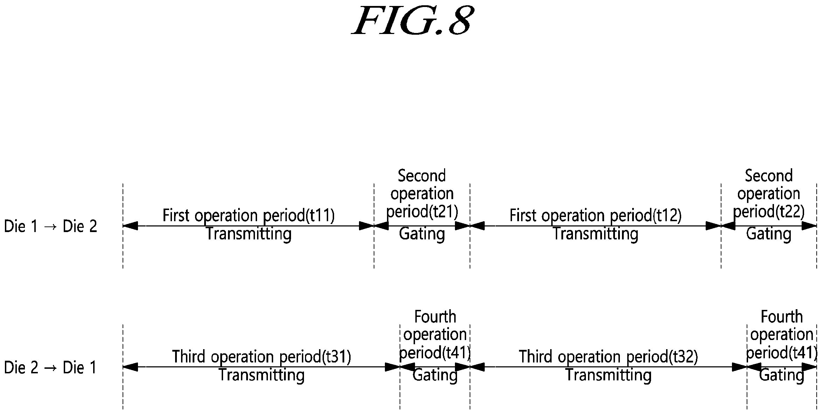

FIG. 7 is a diagram illustrating aa schematic configuration of a semiconductor device according to an embodiment of the disclosure. FIG. 8 is a diagram illustrating a method of operating mask circuits included in semiconductor dies illustrated in FIG. 7.

Referring to FIG. 7, a first semiconductor die 310 may include a first transmission circuit 311, a first reception circuit 312, a first mask circuit 313, a first buffer memory 314 and a first interface 316. The first semiconductor die 310 may include a first clock source 315 and a fourth clock source 317.

The first clock source 315 may output a first clock signal CLK1 to the first transmission circuit 311 and the first mask circuit 313. The first transmission circuit 311 and the first mask circuit 313 may operate on the basis of the first clock signal CLK1, and may output first data Datal to the outside.

The fourth clock source 317 may output a fourth clock signal CLK4 to the first reception circuit 312. The first reception circuit 312 may operate on the basis of the fourth clock signal CLK4, and may read second data Data2 received from a second semiconductor die 320.

The second semiconductor die 320 may include a second transmission circuit 321, a second reception circuit 322, a second mask circuit 323, a second buffer memory 324 and a second interface 326. The second semiconductor die 320 may include a second clock source 325 and a third clock source 327.

The second clock source 325 may output a second clock signal CLK2 to the second reception circuit 322. The second reception circuit 322 may operate on the basis of the second clock signal CLK2, and may read the first data Datal received from the first semiconductor die 310.

The third clock source 327 may output a third clock signal CLK3 to the second transmission circuit 321 and the second mask circuit 323. The second transmission circuit 321 and the second mask circuit 323 may operate on the basis of the third clock signal CLK3, and may output the second data Data2 to the outside.

The first clock signal CLK1, which is used when the first semiconductor die 310 transmits data, may be different from the second clock signal CLK2, which is used when the second semiconductor die 320 reads data. The third clock signal CLK3, which is used when the second semiconductor die 320 transmits data, may be different from the fourth clock signal CLK4, which is used when the first semiconductor die 310 reads data.

By implementing a masking or gating operation using a first mask circuit 313 and a second mask circuit 323, the transmission frequency of the first data Datal and the transmission frequency of the second data Data2 may each be adjusted.

For example, referring to FIG. 8, when the first data Datal is transmitted from the first semiconductor die 310 to the second semiconductor die 320, the first mask circuit 313 may bypass and output the first data Datal during a first operation period, and may stop outputting the first data Datal during a second operation period.

When the second data Data2 is transmitted from the second semiconductor die 320 to the first semiconductor die 310, the second mask circuit 323 may bypass and output the second data Data2 during a third operation period, and may stop outputting the second data Data2 during a fourth operation period.

Lengths t11 and t12 of the first operation period and lengths t21 and t22 of the second operation period may be set on the basis of the difference between the frequency of the first clock signal CLK1 and the frequency of the second clock signal CLK2.

Lengths t31 and t32 of the third operation period and lengths t41 and t42 of the fourth operation period may be set on the basis of the difference between the frequency of the third clock signal CLK3 and the frequency of the fourth clock signal CLK4.

Since the difference between the frequency of the first clock signal CLK1 and the frequency of the second clock signal CLK2 may not be the same as the difference between the frequency of the third clock signal CLK3 and the frequency of the fourth clock signal CLK4, the ratio between the length of the first operation period and the length of the second operation period may be different from the ratio between the length of the third operation period and the length of the fourth operation period.

On the basis of the characteristics of a data transmission operation from the first semiconductor die 310 to the second semiconductor die 320, and the characteristics of a data transmission operation from the second semiconductor die 320 to the first semiconductor die 310, the configuration value of the first mask circuit 313 and the configuration value of the second mask circuit 323 may be set independently.

In addition, on the basis of changes in the condition information of semiconductor dies or the lengths of data to be transmitted, the configuration value of the first mask circuit 313 and the configuration value of the second mask circuit 323 may be set variably.

A clock signal to be used in each semiconductor die may be set so that a transmission fail may be prevented while increasing data transmission speed.

For example, the frequency of the first clock signal CLK1, which is used when transmitting the first data Datal, may be greater than the frequency of the second clock signal CLK2, which is used when reading the first data Datal. The frequency of the third clock signal CLK3, which is used when transmitting the second data Data2, may be greater than the frequency of the fourth clock signal CLK4, which is used when reading the second data Data2.

By increasing the frequency of a clock signal, which is used when transmitting data, and controlling a data transmission fail due to the difference between clock signals through a mask circuit, data transmission and reception performance between semiconductor dies may be improved.

According to the embodiments of the disclosed technology, since output of data is controlled in each operation period by a mask circuit included in a transmission die, transmission of data may be performed at a frequency different from the frequency of a clock signal used in the transmission die. It is possible to improve communication performance while preventing or reducing a data transmission and reception fail due to the difference between the clock signal of the transmission die and the clock signal of a reception die.

Although various embodiments of the disclosed technology have been described with particular specifics and varying details for illustrative purposes, those skilled in the art will appreciate that various modifications, additions and substitutions may be made based on what is disclosed or illustrated in the disclosed technology without departing from the spirit and scope of the disclosed technology as defined in the following claims.

## Claims

1. A semiconductor device comprising:
a first semiconductor die including a first transmission circuit, a first reception circuit and a first mask circuit, the first mask circuit configured to receive a first data, which is output by the first transmission circuit in accordance with a first clock signal, to output the first data to an outside during a first operation period, and to stop the output of the first data during a second operation period; and
a second semiconductor die a second reception circuit, the second reception circuit configured to read the first data, which is transmitted from the first semiconductor die and buffered, in accordance with a second clock signal that is different from the first clock signal.

2. The semiconductor device according to claim 1, wherein at least one of a length of the first operation period and a length of the second operation period is set on the basis of a difference between a frequency of the first clock signal and a frequency of the second clock signal.

3. The semiconductor device according to claim 1, wherein at least one of a length of the first operation period and a length of the second operation period is set on the basis of a size of a buffer memory that is included in the second semiconductor die and that buffers the first data.

4. The semiconductor device according to claim 1, wherein at least one of a length of the first operation period and a length of the second operation period is set on the basis of condition information including at least one of a process, a voltage and a temperature of the first semiconductor die.

5. The semiconductor device according to claim 1, wherein at least one of a length of the first operation period and a length of the second operation period is set on the basis of a length of the first data.

6. The semiconductor device according to claim 1, wherein at least one of a length of the first operation period and a length of the second operation period is variable.

7. The semiconductor device according to claim 1, wherein the second operation period is a period that is continuous with the first operation period.

8. The semiconductor device according to claim 1, wherein the first operation period and the second operation period alternate.

9. The semiconductor device according to claim 1, wherein a frequency of the first clock signal is greater than a frequency of the second clock signal.

10. The semiconductor device according to claim 1, wherein the first mask circuit outputs a transmission ready signal to the first transmission circuit before the first operation period starts.

11. The semiconductor device according to claim 1, wherein the first mask circuit outputs a transmission stop signal to the first transmission circuit before the second operation period starts.

12. The semiconductor device according to claim 1, wherein the first mask circuit comprises:
a first counter configured to operate during the first operation period on the basis of a valid signal that is received together with the first data; and
a second counter configured to operate during the second operation period.

13. The semiconductor device according to claim 12, wherein the second counter operates without the valid signal during at least a part of the second operation period.

14. The semiconductor device according to claim 12, wherein the first mask circuit bypasses and outputs the first data when the first counter operates, and blocks output of the first data when the second counter operates.

15. The semiconductor device according to claim 12, wherein at least one of the first counter and the second counter receives a counter threshold value that is set in proportion to at least one of a length of the first operation period and a length of the second operation period, and a counting operation period is adjusted according to the counter threshold value.

16. The semiconductor device according to claim 1, wherein the second semiconductor die further includes a second transmission circuit and a second mask circuit, and
the second mask circuit receives second data that is output by the second transmission circuit in accordance with the second clock signal, and bypasses and outputs the second data to an outside.

17. The semiconductor device according to claim 1, wherein the second semiconductor die further includes a second transmission circuit and a second mask circuit, and
the second mask circuit receives second data that is output by the second transmission circuit in accordance with a third clock signal that is different from the second clock signal, outputs the second data to an outside during a third operation period, and stops outputting the second data during a fourth operation period.

18. The semiconductor device according to claim 17, wherein the first reception circuit reads the second data, which is transmitted from the second semiconductor die and buffered, in accordance with the first clock signal or in accordance with a fourth clock signal, which is different from the first clock signal.

19. A semiconductor chip comprising:
a transmission circuit configured to output data in accordance with a clock signal; and
a mask circuit configured to receive the clock signal and the data output from the transmission circuit,
wherein the mask circuit bypasses and outputs the data during a first operation period and a second operation period, or bypasses and outputs the data during one of the first operation period and the second operation period, and stops outputting the data during the other period.

20. A data storage system comprising:
at least one memory device; and
a controller configured to control an operation of the at least one memory device,
the controller comprising
a first chiplet including a mask circuit that receives data in accordance with a first clock signal, outputs the data to an outside during a first operation period, and stops output of the data during a second operation period; and
a second chiplet including a buffer memory that receives and stores the data, and a reception circuit that reads the data stored in the buffer memory in accordance with a second clock signal that is different from the first clock signal.
